# EUROPÄISCHE PATENTSCHRIFT

(11) **EP 0 655 651 B1**
(45) Veröffentlichungstag und Bekanntmachung des Hinweises auf die Patenterteilung: **30.07.1997**
(21) Anmeldenummer: 94118107.5
(22) Anmeldetag: 17.11.1994
(51) Int. Cl.: G03F 3/10, G03F 7/105

(54) **Lichtempfindliches Material und Verfahren zur Herstellung von metallfarbigen Bildern**
Photosensitive material and process for making images bearing metal-like colours
Matériau photosensible et procédé pour fabriquer des images en couleur d'apparence métallique

(30) Priorität: 26.11.1993 DE 4340335
(43) Veröffentlichungstag der Anmeldung: 31.05.1995
(73) Patentinhaber: Agfa-Gevaert AG, 51373 Leverkusen (DE)
(72) Erfinder: März, Karin, Dr., D-55128 Mainz (DE); Neumann, Silvia, D-65185 Wiesbaden (DE); Mohr, Dieter, Dr., D-55437 Appenheim (DE)

(56) Entgegenhaltungen:
- EP-A- 0 129 028
- EP-A- 0 197 396
- EP-A- 0 437 343
- EP-A- 0 503 402
- EP-A- 0 525 624

## Beschreibung

Die Erfindung betrifft ein lichtempfindliches Material für die Herstellung von Farbbildern, insbesondere von Farbprüffolien, in Metalleffektfarben, die als Schmuck- und Sonderfarben im Mehrfarbendruck eingesetzt werden. Sie betrifft femer ein Verfahren, bei dem auf ein farbiges Prüfbild nach dessen Herstellung Teilfarbenbilder in Metalleffektfarben im Register aufgebracht werden können.

Der Mehrfarbenoffsetdruck ist heute durch steigende Ansprüche an die Druckqualität gekennzeichnet. Sonderfarben sowie Veredelung durch Gold-, Silber- und andere Metalleffekte gewinnen insbesondere auf dem Verpackungssektor zunehmend an Bedeutung. Während viele Sonderfarben durch Abmischungen oder Übereinanderdrucken der Basisfarben des Mehrfarbendrucks eingestellt werden können, ist das Erzielen von Metalleffekten auf diesem Wege nicht möglich.

Eine bekannte Möglichkeit zur Erzeugung von Metalleffekten auf Farbprüfbildern ist ein bildmäßiges Betonern mit Tonerpuder in Metalleffektfarben (US-A 5 122 437), vergleichbar mit dem Bronzieren von Offsetdrucken. Dabei wird eine photopolymerisierbare, farblose Schicht bildmäßig belichtet. Durch die Belichtung erfolgt eine Veränderung der Haftkraft der Oberfläche der photopolymerisierbaren Schicht, so daß aufgrund der unterschiedlichen Klebrigkeit von Bild- und Nichtbildstellen eine bildmäßige Betonerung möglich wird. Metalleffekte können dabei durch die Verwendung von speziellen Tonern (z. B. "Cromalin^{(R)} metallic gold") erzielt werden. Das Verfahren ist sowohl für positiv wie auch für negativ arbeitende Farbprüfsysteme geeignet, sofern eine ausreichende Klebrigkeitsdifferenzierung erreicht wird. Der Vorteil dieses Verfahrens ist, daß der Bildeindruck nicht durch zusätzliche Trägerschichten verfälscht wird. Ein Nachteil ist die aufwendige und beschwerliche Handhabung des Tonerpuders.

Eine weitere Möglichkeit zur Erzeugung von Metalleffekten auf Farbprüfbildern ist ein Verfahren, bei dem nach der Fertigstellung eines Farbprüfbilds Schmuckfarben durch spezielle lichtempfindliche Metallfolien erzeugt werden, wie es in der JP-A 123 130/78 (Chem. Abstr. 90/144 322) beschrieben ist. Diese Folien bestehen aus mit Metallen oder Metallverbindungen beschichteten Polyesterfolien. Auf der Metallschicht befinden sich eine lichtempfindliche Schicht und gegebenenfalls mindestens eine Deckschicht. Das Material wird bildmäßig auf der Seite der lichtempfindlichen Schicht belichtet, etwa drei Minuten mit 60 °C heißem Wasser behandelt und durch Abziehen der lichtempfindlichen Schicht, gegebenenfalls zusammen mit den Deckschichten, entwickelt, wobei die Metallschicht an den belichteten Stellen auf der Polyesterträgerfolie verbleibt und dort ein metallfarbiges Negativ der Belichtungsmaske erzeugt. Bei negativ arbeitenden Verfahren nach dem Overlay-Prinzip (z. B. gemäß US-A 4 489 153) kann das abgezogene Metallfoliennegativ direkt verwendet werden. Bei negativ arbeitenden Surprint-Verfahren (z. B. gemäß EP-A 0 165 031) kann dieses Metallbild auf ein fertiges Farbprüfbild laminiert werden. Gegebenenfalls muß vor dem Laminieren des Metallbilds eine zusätzliche Haftschicht auf die Oberfläche des Prüfbilds oder des Metallbilds aufgebracht werden. Da sich die abgezogene lichtempfindliche Schicht, die das positive Metallbild trägt, aufgrund der in ihr enthaltenen Substanzen (Diazoniumverbindungen) unter Lichteinwirkung verfärbt, ist das Positiv dagegen für Farbprüfverfahren ungeeignet.

Die Hauptnachteile dieses auf negativ arbeitende Systeme beschränkten Verfahrens zur Erzeugung von Metalleffekten sind die zur Entwicklung erforderliche, insbesondere bei großen Formaten aufgrund der notwendigen Gleichmäßigkeit schwierige Behandlung mit heißem Wasser und der Verbleib der 100 µm starken Polyesterträgerfolie auf der Prüfbildoberfläche, wodurch aufgrund von Lichtstreueffekten der für die Qualität eines Farbprüfverfahrens entscheidende Bildeindruck verfälscht wird.

In der EP-A 0 550 338 wird ein Verfahren und Material zur Herstellung von metallfarbigen Farbprüfbildern beschrieben, bei dem ein lichtempfindliches Material aus einer temporären Trägerfolie, einer metallfarbigen Pigmentschicht, einer Farbpigmentschicht, einer Photoresistschicht, ggf. einer Haftschicht und weiteren Zwischenschichten auf ein Bildempfangsmaterial laminiert, bildmäßig belichtet und durch Auswaschen entwickelt wird. Jede Pigmentschicht kann auch zugleich Photoresistschicht sein. Das Material hat stets zwei Pigmentschichten, durch die hindurch belichtet werden muß. Dadurch wird die Bildbelichtung und die danach folgende Auswaschentwicklung erschwert. Eine peel-apart-Entwicklung ist bei diesen doppelten Pigmentschichten nicht möglich.

Ein anderes Farbprüfverfahren und ein hierfür vorgesehenes Material sind aus den US-A 4 895 787 und 5 049 476 (= EP-A 0 437 343) bekannt. Dieses Material besteht aus einer transparenten Trägerfolie, einer lichtempfindlichen Schicht, die einen Farbstoff oder ein Farbpigment in einer Grundfarbe des Mehrfarbendrucks enthält und einer thermoplastischen, durch Erwärmen aktivierbaren Haftschicht auf der photopolymerisierbaren Schicht. Das Material wird nach Laminieren auf ein Bildempfangsmaterial durch die Trägerfolie hindurch belichtet und dann durch Auseinanderziehen ("peel apart") von Trägerfolie und Bildempfangsmaterial entwickelt. Dabei verbleiben die belichteten Bereiche der lichtempfindlichen Farbschicht an der Trägerfolie, während die unbelichteten Bereiche zusammen mit der gesamten Haftschicht auf dem Bildempfangsmaterial verbleiben.

In der EP-A 0 129 028 ist ein strahlungshärtbares Gemisch mit mindestens einem durch Polymerisation oder Vernetzung härtbaren Monomer oder Präpolymer, einem Perlglanzpigment sowie gegebenenfalls einem die Härtung auslösenden Initiator offenbart. Es dient zur Erzeugung von dekorativen Überzügen auf flächigen Materialien, wie Holz, Papier oder Metall. Insbesondere werden damit Etiketten, Schallplattenhüllen, Buchumschläge, Bleche für Tuben-, Dosenoder Flaschenverschlüsse, Keramikfliesen oder Dachziegel lackiert. In den Beispielen der EP-A haben die damit hergestellten Überzüge eine Dicke von 24 bis 250 µm.

In der EP-A 0 197 396 ist ein Verfahren zur Herstellung einer Farbprüffolie (Color-Proof) beschrieben. Darin wird ein lichtempfindliches Material eingesetzt, das auf einem Schichtträger eine Trennschicht, eine photopolymerisierbare Schicht und eine Haftschicht trägt, wobei die Trennschicht an dem Schichtträger weniger haftet als an der photopolymerisierbaren Schicht. Die photopolymerisierbare Schicht enthält einen Farbstoff oder - vorzugsweise - ein feingemahlenes Pigment. Das lichtempfindliche Material kann mit der Haftschicht auf ein Bildempfangsblatt laminiert werden. Danach wird der Schichtträger abgezogen. Nach dem bildmäßigen Belichten werden die Trennschicht und die unbelichteten Bereiche der photopolymerisierbaren Schicht mit einer Entwicklerlösung ausgewaschen. Auf diese Weise erhält man ein Bild in einer Teilfarbe. Durch Aufeinanderlaminieren mehrerer so hergestellter Teilfarbenbilder läßt sich auch ein mehrfarbiger Color-Proof herstellen.

Aufgabe der Erfindung war es, ein lichtempfindliches Material für die Herstellung metallfarbiger Bilder vorzuschlagen, das sich bequem und zuverlässig wie ein übliches Farbprüfmaterial verarbeiten und insbesondere mit aus solchem Material erhaltenen Teilfarben- oder Mehrfarbenbildern kombinieren läßt, ohne daß dabei Verarbeitungsparameter verändert werden müssen.

Gegenstand der Erfindung ist ein lichtempfindliches Material für die Herstellung metallfarbiger Bilder aus
A) einer transparenten flexiblen Trägerfolie aus Kunststoff,
B) einer 0,5 bis 20 µm dicken, lichtempfindlichen Schicht, die ein polymeres Bindemittel, eine lichtempfindliche Substanz und ein Pigment enthält, sowie
C) einer thermoplastischen Haftschicht.

Das erfindungsgemäße Material ist dadurch gekennzeichnet, daß das Pigment ein Perlglanzpigment ist.

Das erfindungsgemäße lichtempfindliche Material kann außer den angegebenen Schichten (A), (B) und (C) noch weitere Schichten, z. B. Trennschichten oder temporäre Abdeckfolien, enthalten.

Die in dem erfindungsgemäßen Material eingesetzten Perlglanzpigmente sind bekannt und z. B. in Ullmann, Encycl. of Ind. Chem., Verlag Chemie, Weinheim 1988, Band 20, Kapitel 4.3, S. 347 ff; in "Perlglanzpigmente" von R. Maisch und M. Weigand aus der Reihe Bibliothek der Technik, Band 56, Verlag Moderne Industrie, Landsberg/Lech (1991), und in den US-A 4 134 776 und 4 344 987 beschrieben. Auch in der oben genannten EP-A 0 550 338 sind Perlglanzpigmente beschrieben. Die Perlglanzpigmente sind vorzugsweise anorganischer Natur. Sie enthalten im allgemeinen Trägermaterialien, die aus bevorzugt transparenten mineralischen Partikeln bestehen, z. B. aus Schichtsilikaten, die zumeist Durchmesser von weniger als 50 µm, bevorzugt von 5 bis 20 µm haben. Diese häufig in Form von Plättchen vorliegenden Partikel sind auf ihrer Oberfläche mit Pigmenten, vor allem Metalloxiden, wie Eisenoxide, Titandioxid, Chromoxid oder dgl., anderen anorganischen Pigmenten wie Berliner Blau oder auch organischen Pigmenten wie Carminrot oder Thioindigo belegt.

Die Vorteile der Perlglanzpigmente gegenüber herkömmlichen Metallpigmenten bestehen in ihrer geringen Dichte und in ihrer Transparenz. Die geringe Dichte erlaubt eine Herstellung der Farbfolien durch Beschichtung der Trägerfolien aus einer Lösung, die die Pigmente in Form einer Dispersion enthält. Die Transparenz gewährleistet einen ausreichenden Lichtkontakt der Bestandteile der lichtempfindlichen Schicht während einer Belichtung.

Die verwendeten Perlglanzpigmente bestimmen die später zu erzeugende Schmuckfarbe. Durch Mischung der Perlglanzpigmente mit anderen Farbpigmenten können dabei aufgrund der Transparenz der Perlglanzpigmente interessante Mischeffekte auftreten. So kann durch Zusatz geringer Mengen schwarzen Pigments [z. B. ^{(R)}Printex 25 (Ruß)] zu einem weißen Perlglanzpigment die Schmuckfarbe Silber erzeugt werden. Beispiele für geeignete handelsübliche Perlglanzpigmente sind: ^{(R)}Iriodin 111 Rutil Fine Satin, Iriodin 123 Bright Lustre Satin, Iriodin 302 Goldsatin, Iriodin 323 Royalgoldsatin und Iriodin 520 Bronzesatin (E. Merck GmbH, Darmstadt). Die Wahl der Pigmente richtet sich auch nach der Schichtdicke der Schicht, in der sie eingesetzt werden. Diese beträgt bei der lichtempfindlichen Schicht des erfindungsgemäßen Materials im allgemeinen 0,5 bis 20 µm, vorzugsweise 1 bis 10 µm. Ist der Plättchendurchmesser der Perlglanzpigmente zu groß, ist in vielen Fällen eine schlechte Auflösung der mit ihnen hergestellten Farbprüffolien die Folge. Daher sind Perlglanzpigmente, die wie die genannten Beispiele einen Plättchendurchmesser von weniger als 20 µm haben, besonders geeignet.

Die Perlglanzpigmente werden in eine Bindemittellösung aus dem Bindemittel der lichtempfindlichen Schicht und einem für dieses Bindemittel geeigneten Lösemittel eingerührt. Der Dispergiervorgang sollte nicht in einer Perlmühle durchgeführt werden, da dabei die zur Erzielung des Glanzeffektes notwendige Plättchenstruktur der Perlglanzpigmente zerstört würde. Ein Beschichtungsverfahren, bei dem sich die Pigmentplättchen parallel zur Oberfläche anordnen können, also z. B. Beschichtung durch Schlitzdüsen oder durch Rakeln, ist für den Glanzeffekt besonders vorteilhaft.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die weitere Zusammensetzung der lichtempfindlichen Schicht richtet sich nach der gewünschten Arbeitsweise, d. h. ob die Schicht zu positiven oder negativen Bildern verarbeitet wird und ob die Entwicklung durch Auswaschen oder Auseinanderziehen ("peel-apart") erfolgt, und ist im folgenden für die verschiedenen Systeme beschrieben.

Wenn das Material durch peel-apart-Entwicklung in der Weise verarbeitet werden soll, daß ein positives "Surprint"-Farbprüfbild oder ein negatives "Overlay"-Prüfbild erhalten wird, enthält die lichtempfindliche Schicht als wesentliche Bestandteile das bereits beschriebene polymere Bindemittel oder Bindemittelgemisch, eine radikalisch polymerisierbare Verbindung, einen Photoinitiator bzw. eine Photoinitiatorkombination und ein oder mehrere Farbpigmente, von denen mindestens eines ein Perlglanzpigment ist.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacrylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Als Photoinitiatoren sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z. B. Trichlormethyl-s-triazine. Vorteilhaft sind 2,3-Bis-aryl-chinoxaline, wie sie in der US-A 3 765 898 beschrieben sind, und 2-Aryl-4,6-bis-trichlormethyl-s-triazine. Die Menge an Photoinitiator bzw. an Photoinitiatorkombination liegt im allgemeinen zwischen 1 und 25, vorzugsweise zwischen 3 und 15 Gew.-%

Die photopolymerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Haftvermittler, Antistatika, inerte Füllstoffe, optische Aufheller und/oder UV-Absorber, enthalten.

Auf die lichtempfindliche Schicht wird dann eine thermisch aktivierbare Haftschicht aufgebracht, die ein thermoplastisches Bindemittel enthält. Die Haftschicht sollte eine Erweichungstemperatur von 40 - 200 °C, vorzugsweise von 60 - 130 °C haben. Sie kann entweder aus einem Lösemittel oder Lösemittelgemisch direkt auf die lichtempfindliche Schicht oder auch zuerst auf eine temporäre Trägerfolie aufgebracht und getrocknet werden. Von der temporären Trägerfolie aus kann die Haftschicht durch Laminieren und Abziehen der Trägerfolie entweder auf die lichtempfindliche Schicht oder auf ein Bildempfangsmaterial übertragen werden. Erfolgt der Übertrag auf das Bildempfangsmaterial, dann wird die lichtempfindliche Schicht in einem zweiten Schritt auf die so erhaltene Haftschicht laminiert. Das direkte Aufbringen der Haftschicht auf die photopolymerisierbare Schicht aus Lösemitteln wird bevorzugt. Geeignete Lösemittel, die die lichtempfindliche Schicht nicht anlösen, sind Wasser und gesättigte Kohlenwasserstoffe. Viele Polymere können auch aus Dispersion aufgebracht werden.

Als Bindemittel eignen sich alle Polymeren, mit denen sich eine Haftschicht mit der genannten Erweichungstemperatur herstellen läßt. Besonders bevorzugt sind Vinylacetat-, Acrylat- oder Methacrylathomo- und -copolymere. Ferner kann auch eine Mischung von Polymeren und der Zusatz von Haftvermittlern und Weichmachern von Vorteil sein. Zur Reduktion der Oberflächenklebrigkeit können Partikel zugesetzt werden, die sich in der Haftschichtlösung nicht lösen (US-A 4 889 787). Besonders bevorzugt sind kieselsäurehaltige Pigmente. Als weitere Bestandteile kann die Haftschicht Restlöser, Oberflächenausgleichsmittel, Gleitmittel, Antistatika, optische Aufheller und/oder UV-Absorber enthalten. Ihr Schichtgewicht im trockenen Zustand beträgt normalerweise 2 bis 30, vorzugsweise 3 bis 15 g/m².

Zur Durchführung des erfindungsgemäßen Verfahrens wird das vorstehend beschriebene Material mit der Haftschicht auf ein Bildempfangsmaterial laminiert. Dieses kann aus Kunststoff, kunststoffbeschichtetem Spezialpapier oder Bedruckpapier bestehen. Das Bildempfangsmaterial kann auch bereits Teilfarbenbilder tragen, die nach einem bekannten Farbprüfverfahren hergestellt worden sind. Ein unter den Laminationsbedingungen maßhaltiges Bedruckpapier oder ein gemäß US-A 4 895 787 oder 5 049 476 hergestelltes Farbprüfbild wird als Empfangsmaterial für die erfindungsgemäßen Metalleffektbilder bevorzugt.

Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130 °C. Vor oder bevorzugt nach dem Laminieren wird das Material durch die Trägerfolie hindurch unter einer Positiv-Maske bildmäßig belichtet. Nach dem Belichten wird die Trägerfolie mit der Hand oder in einer geeigneten Vorrichtung abgezogen. Der Abziehwinkel sollte mindestens 90° betragen; ein Winkel von 180° wird bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives, metallfarbiges Bild erhalten.

Dieses Verfahren hat den großen Vorteil, daß es zur Entwicklung keine alkalischen oder sauren Lösungen und keine organischen Lösemittel erfordert, deren Entsorgung damit entfällt.

Gemäß einer anderen Ausführungsform des erfindungsgemäßen Verfahrens kann die Verarbeitung auch so ausgeführt werden, daß das Material ein negatives Surprint-Farbprüfbild durch peel-apart-Entwicklung ergibt. Der Aufbau des Materials ist identisch mit dem vorstehend beschriebenen Material für ein positiv arbeitendes peel-apart Farbprüfverfahren. Der Unterschied liegt in der Verarbeitungsweise. Um ein negatives Abbild der Bildvorlage auf dem Bildempfangsmaterial zu erhalten, wird nach dem Laminieren die Trägerfolie durch Abziehen entfernt. Auf dem Empfangsmaterial bleiben die Haftschicht und die unbelichtete lichtempfindliche Schicht zurück, die nun unter einem Farbauszugsfilm bildmäßig belichtet wird. Nach der Belichtung wird eine transparente Polyesterfolie, die bevorzugt ein- oder beidseitig haftvermittelt ist und ggf. auch die nach dem Laminieren abgezogene Trägerfolie sein kann, auf die bildmäßig belichtete Schicht laminiert. Nach diesem Laminierschritt wird durch die Polyesterfolie hindurch die gesamte Schicht nachbelichtet. Die Polyesterfolie wird anschließend abgezogen; dabei bleiben die bildmäßig belichteten und damit photopolymerisierten Bereiche zusammen mit der Haftschicht auf dem Bildempfangsmaterial, während die unbelichteten, erst während der Nachbelichtung photopolymerisierten Bereiche zusammen mit der Polyesterfolie entfernt werden. Auf dem Empfangsblatt verbleibt ein negatives Bild der Belichtungsvorlage. Nach diesem Prinzip arbeitende Verfahren sind bekannt und z. B. in der US-A 4 987 051 beschrieben.

Wenn das erfindungsgemäße lichtempfindliche Material positiv verarbeitet und durch Auswaschen entwickelt werden soll, enthält die lichtempfindliche Schicht neben dem beschriebenen polymeren Bindemittel oder Bindemittelgemisch und dem Perlglanzpigment ein Chinondiazid oder ein Diazoniumsalz als lichtempfindliche Substanz. Bevorzugt wird ein Ester aus einer o-Chinon-diazidsulfonsäure (z. B. 1,2-Naphthochinon-2-diazid-4-sulfonsäure) und einer Verbindung mit mindestens einer phenolischen Hydroxygruppe (z. B. 2,3,4-Trihydroxybenzophenon).

Ferner ist es von Vorteil, wenn sich zwischen der Trägerfolie und der beschriebenen lichtempfindlichen Schicht eine Trennschicht befindet. Bevorzugte Bestandteile für eine solche Trennschicht sind Polyvinylalkohol oder teilverseifte Polyvinylacetate.

Nachdem auf die lichtempfindliche Schicht die weiter oben beschriebene Haftschicht aufgetragen worden ist, wird das erfindungsgemäße Material mit dieser Haftschicht mit Hilfe von Wärme und Druck auf ein Bildempfangsmaterial laminiert; die temporäre Trägerfolie wird entfernt und das Laminat unter einer Maske für die Metalleffektfarben belichtet. Die bildmäßig belichtete Schicht kann in bekannter Weise mit wäßrig-alkalischen Entwicklerlösungen entwickelt werden. Dabei werden die belichteten Stellen entfernt, während die unbelichteten Bildbereiche mit der gesamten Haftschicht auf dem Bildempfangsmaterial verbleiben und ein positives Abbild der Belichtungsmaske darstellen.

Die wäßrigen Entwicklerlösungen können dabei z. B. Alkaliphosphate, -silikate, -sulfate und/oder -hydroxide sowie Netzmittel und gegebenenfalls geringe Mengen organischer Lösemittel enthalten.

Ein negativ arbeitendes, durch Auswaschen entwickelbares Material wird wie folgt hergestellt und verarbeitet:

Die lichtempfindliche Schicht enthält hier neben dem beschriebenen polymeren Bindemittel oder Bindemittelgemisch und dem Perlglanzpigment bevorzugt eine polymere Diazoverbindung als lichtempfindliche Substanz. Es sind aber auch entsprechende Materialien auf Photopolymerbasis bekannt (US-A 4 629 680 und 4 624 910). Bei der polymeren Diazoverbindung kann es sich z. B. um ein Polykondensationsprodukt aus einem p-Diazodiphenylamin und Formaldehyd handeln. Weitere Beispiele für polymere Diazoverbindungen sind in der Literatur beschrieben (z. B. in US-A 4 650 738, EP-A 0 165 031 und US-A 3 849 392). Auf die lichtempfindliche Schicht wird die beschriebene Haftschicht aufgetragen. Das Material kann ferner zusätzliche Schichten wie Trennschichten oder Schichten zur Sauerstoffsperre enthalten.

Das erfindungsgemäße Material wird mit der Haftschicht auf ein temporäres oder permanentes Bildempfangsmaterial laminiert; bevorzugt wird die temporäre Trägerfolie entfernt und das Laminat unter einer Maske belichtet. Die Belichtung kann aber auch vor dem Laminieren durch die Trägerfolie hindurch erfolgen. Die bildmäßig belichtete Schicht kann in bekannter Weise mit Entwicklerlösungen, vorzugsweise auf wäßrig-alkalischer Basis, entwickelt werden. Dabei werden hier die unbelichteten Stellen entfernt, während die belichteten Bildbereiche mit der gesamten Haftschicht auf dem Bildempfangsmaterial verbleiben und ein negatives Abbild der Belichtungsmaske bilden.

Die Erfindung wird durch die folgenden Beispiele erläutert. Alle Prozentangaben und Mengenverhältnisse sind in Gewichtseinheiten zu verstehen. Mengen sind zumeist in Gewichtsteilen (Gt) angegeben.

### Beispiel 1

### Herstellung der Perlglanzpigmentdispersionen

### 1.1 Gold

Es wurde eine Bindemittellösung aus
- 10 Gt: Polyvinylformal (Formvar^{(R)} 12/85, Monsanto) und
- 70 Gt: *Y*-Butyrolacton
hergestellt. Zu dieser Bindemittellösung wurden 20 Gt Perlglanzpigment Iriodin 323 Royalgoldsatin (Trägermaterial Glimmer, C.I. 77 019; belegt mit den Pigmenten Eisen-III-oxid, C.I. 77 491; Titandioxid (Rutil), C.I. 77 891 und Zinndioxid, C.I. 77 861) gegeben. Das Pigment wurde mit einem hydraulisch betätigten Rührer, ausgestattet mit einer Dissolverscheibe, d. h. einer horizontal angeordneten kreisförmigen Scheibe aus Edelstahl mit axial hervorstehenden Zähnen, in die Bindemittellösung eingearbeitet. Die Rührzeit betrug 1 Stunde bei 3700 U/min.

### 1.2 Bronze

In die Bindemittellösung aus 1.1 wurden 20 Gt des Perlganzpigments Iriodin 520 Bronzesatin (Trägermaterial Glimmer, belegt mit Eisen-III-oxid) in der unter 1.1 beschriebenen Weise eingearbeitet.

### 1.3 Silber

In die Bindemittellösung aus 1.1 wurden 20 Gt des Perlglanzpigments Iriodin 123 Bright Lustre Satin (Trägermaterial Glimmer, belegt mit Rutil und Zinndioxid) in der unter 1.1 beschriebenen Weise eingearbeitet. Zu 70 Gt dieser weißen Dispersion wurden 0,3 Gt einer schwarzen Pigmentdispersion gegeben, die in der folgenden Weise hergestellt wurde:

Es wurde zunächst eine Bindemittellösung aus

| | |
|---|---|
| 11 Gt | Polyvinylformal wie in 1.1 |
| 100 Gt | *Y*-Butyrolacton |

hergestellt.

Zu dieser Bindemittellösung wurden 13,7 Gt Rußpigment (Printex 25), gegeben.

Die Herstellung der Dispersion erfolgte in einer Kugelmühle bei 1200 U/min unter Verwendung von Glaskugelm mit einem Durchmesser von 1 mm als Mahlkörper.

Die folgenden Beispiele beschreiben ein positiv arbeitendes peel-apart Verfahren:

### Beispiel 2

### Herstellung der Gold-, Bronze- und Silberfolien

Beschichtungslösungen der folgenden Zusammensetzung wurden auf 50 µm dicke, biaxial verstreckte und thermofixierte Polyethylenterephthalatfolien, die auf beiden Seiten zur Haftverbesserung vorbehandelt waren (^{(R)}Melinex 454), aufgebracht und getrocknet.

| **Bestandteil** | **Gewichtsteile** | | |
|---|---|---|---|
| | **Gold** | **Silber** | **Bronze** |
| Dipentaerythritpentaacrylat | 48,2 | 48,2 | 48,2 |
| Polyvinylformal wie bei 1.1 | 17,4 | 17,4 | 17,4 |
| 2-Biphenylyl-(4)-4,6-bis-trichlormethyl-s-triazin | 9,4 | 9,4 | 9,4 |
| Silikonöl als Verlaufmittel (^{(R)}Edaplan LA 411) | 0,6 | 0,6 | 0,6 |
| Gold-Dispersion 1.1 | 450,0 | - | - |
| Bronze-Dispersion 1.2 | - | 450,0 | - |
| Silber-Dispersion 1.3 | - | - | 450,0 |
| Tetrahydrofuran | 750,0 | 750,0 | 750,0 |
| 1-Methoxy-propan-2-ol | 375,0 | 375,0 | 375,0 |

Das Schichtgewicht dieser lichtempfindlichen Schichten betrug 2,5 g/m². Auf die lichtempfindliche Schicht wurde jeweils eine Haftschichtlösung der folgenden Zusammensetzung aufgebracht und getrocknet:

| **Bestandteil** | **Gewichtsteile** |
|---|---|
| Polyacrylat ^{(R)}Carboset XL 11, Säurezahl 75; Tg 55 °C; M_{w} 40.000 | 10 |
| Polyacrylat Carboset XL 37, Säurezahl 75; Tg 42 °C; M_{w} 30.000 | 8 |
| deionisiertes Wasser | 22 |

Das Schichtgewicht der Haftschichten betrug 5,5 g/m².

Diese metallfarbigen Folien wurden in einer Vorrichtung mit einem beheizten Walzenpaar bei 115 °C mit der Haftschicht auf ein Empfangsblatt aus kunststoffbeschichtetem Spezialpapier laminiert und unter einem Farbauszugsfilm durch die Trägerfolie hindurch belichtet. Dann wurde die Trägerfolie kontinuierlich in einem Winkel von 180° vom Empfangsblatt abgezogen, wobei die unbelichteten Schichtbereiche zusammen mit der Haftschicht auf dem Empfangsblatt zurückblieben. Es wurde ein positives gold-, silber- oder bronzefarbiges Teilbild erhalten. Die Auflösung betrug 30 µm.

### Beispiel 3

Auf die lichtempfindlichen Schichten aus Beispiel 2 wurde jeweils eine Haftschichtlösung der folgenden Zusammensetzung aufgebracht und getrocknet:

| **Bestandteil** | **Gewichtsteile** |
|---|---|
| Carboset XL 11 | 20 |
| Polyacrylat Carboset XL 19, (Säurezahl 32; Tg 26 °C; M_{w} 30.000) | 10 |
| deionisiertes Wasser | 20 |

Das Schichtgewicht der Haftschicht betrug 5,5 g/m².
Die Weiterverarbeitung der Folien zu metallfarbigen Bildern erfolgte in der in Beispiel 2 beschriebenen Weise.

### Beispiel 4

Es wurde in der in Beispiel 1.1 beschriebenen Weise eine Perlglanzpigmentdispersion aus:

| | |
|---|---|
| 10 Gt | Polyvinylformal wie in Beispiel 1.1 |
| 10 Gt | Goldsatinpigment wie in Beispiel 1.1 |
| 10 Gt | Iriodin 302 Goldsatin (Trägermaterial Glimmer; belegt mit Eisen-III-oxid und Titandioxid (Anatas) C.I. 77 891) und |
| 70 Gt | *Y*-Butyrolacton |

hergestellt.

Diese Dispersion wurde zur Herstellung einer Beschichtungslösung der in Beispiel 2 angegebenen Zusammensetzung verwendet, indem die Golddispersion aus 1.1 durch die gleiche Menge der vorstehend angegebenen Dispersion ersetzt wurde.

Auf die lichtempfindliche Schicht wurde jeweils eine Haftschichtlösung der folgenden Zusammensetzung aufgebracht und getrocknet.

| **Bestandteil** | **Gewichtsteile** |
|---|---|
| Polyacrylat Carboset 525, Säurezahl 80; Tg 37 °C; M_{w} 260.000 | 10 |
| Carboset XL 37 | 114 |
| deionisiertes Wasser | 208 |
| wäßrige Ammoniaklösung (25 %) | 1 |

Die Weiterverarbeitung erfolgte in der in Beispiel 2 beschriebenen Weise. Im Vergleich zu den rotgoldenen Bildern aus Beispiel 2 wurde hier eine hellere, gelbgoldene Farbe erzielt.

### Beispiel 5

Es wurden Farbfolien in den vier Grundfarben des Mehrfarbendrucks hergestellt. Auf wie in Beispiel 2 angegebene vorbehandelte Polyesterfolien wurden lichtempfindliche Farblösungen der folgenden Zusammensetzung aufgebracht und getrocknet:

| **Bestandteil** | **Gewichtsteile** | | | |
|---|---|---|---|---|
| | Blaugrün | Purpur | Gelb | Schwarz |
| Dipentaerythritpentaacrylat | 39,0 | 35,5 | 38,2 | 36,1 |
| Polyvinylformal wie bei 1.1 | 31,3 | 36,5 | 35,4 | 28,9 |
| 2-Biphenylyl-(4)-4,6-bis-trichlormethyl-s-triazin | 9,8 | 7,8 | 9,5 | 9,6 |
| Hostapermblau B2G (C.I. 74160) | 19,0 | - | - | - |
| Permanentcarmin FBB (C.I. 12485) | - | 18,5 | - | - |
| Permanentgelb DR (C.I. 21100) | - | 0,7 | 16,4 | - |
| Ruß (Printex 25) | 0,4 | 0,5 | - | 24,8 |
| Silikonöl wie in Beispiel 2 | 0,5 | 0,5 | 0,5 | 0,6 |
| Tetrahydrofuran | 1000 | 1000 | 1000 | 1000 |
| 1-Methoxy-propan-2-ol | 680 | 680 | 680 | 680 |
| Butyrolacton | 190 | 190 | 190 | 190 |

Die Pigmente wurden zuvor mit dem Butyrolacton und einem Teil des Bindemittels in einer Kugelmühle dispergiert. Die mittlere Teilchengröße lag unterhalb von 0,2 µm. Das Trockengewicht der Farbschichten betrug 0,55 bis 0,85 g/m².

Auf die lichtempfindliche Schicht wurde jeweils eine Haftschichtlösung von

| | |
|---|---|
| 96,57 Gt | Vinylacetat/Crotonsäure-Mischpolymerisat (95:5), |
| 1,36 Gt | Natriumsulfit, |
| 0,15 Gt | pyrogener Kieselsäure, mittlere Teilchengröße 4 µm (^{(R)}Syloid ED 4) in |
| 520 Gt | Wasser, |
| 43 Gt | Ethanol und |
| 8,5 Gt | wäßrigem Ammoniak (25 %) |

aufgebracht und zu einem Schichtgewicht von 6,5 g/m² getrocknet.

Eine der auf diese Weise erhaltenen Farbfolien (z. B. Blaugrün) wurde in einer Vorrichtung mit einem beheizten Walzenpaar bei 115 °C mit der Haftschicht auf ein Empfangsblatt aus Papier laminiert und durch die Trägerfolie hindurch unter dem entsprechenden Farbauszugsfilm belichtet. Dann wurde die Trägerfolie von dem Empfangsblatt abgezogen, wobei die unbelichteten Bereiche zusammen mit der Haftschicht auf dem Empfangsblatt zurückblieben. In der gleichen Weise wurden nacheinander die Purpur-, Gelb- und Schwarzfolie auf das Empfangsblatt über das vorhergehende Teilfarbenbild laminiert, unter dem entsprechenden Farbauszug registergerecht belichtet und durch Abziehen der Trägerfolie entwickelt.

Auf das so erhaltene Farbprüfbild als Empfangsmaterial wurde eine metallfarbige Farbprüffolie aus den Beispielen 2, 3 oder 4 in der beschriebenen Weise laminiert und unter einem Farbauszug für die entsprechende Schmuckfarbe belichtet. Die Trägerfolie wurde abgezogen. Die metallfarbige Schicht blieb in den unbelichteten Bereichen auf der Oberfläche des Farbprüfbilds als positives Abbild der Vorlage zurück. Aufgrund der Transparenz der Perlglanzpigmente wurden an den Stellen, an denen die Bildstellen des Metallbilds und die des Mehrfarbenbilds übereinanderlagen, interessante Mischeffekte erzeugt. So entsteht z. B. durch Silber über Cyan eine blaue Metallicfarbe wie sie von Autolacken her bekannt ist. Sind diese Mischeffekte unerwünscht, müssen die metallfarbigen Bildstellen über Nichtbildstellen des Vierfarbenbildes liegen. Dazu werden die entsprechenden Bereiche in den Vorlagen maskiert.

### Beispiel 6

Anstelle eines trocken entwickelten vierfarbigen Prüfbildes gemäß Beispiel 5 oder eines kunststoffbeschichteten Spezialpapiers wie in Beispiel 2 wurde als Bildempfangsmaterial für die metallfarbigen Folien aus Beispiel 2, 3 oder 4 ein mehrfarbiges Prüfbild verwendet, das zuvor mit dem handelsüblichen Farbprüfsystem ^{(R)}Matchprint der Minnesota Mining and Manufacturing Co. gemäß den entsprechenden Arbeitsanleitungen hergestellt worden war. Das Laminieren der metallfarbigen Folien erfolgt bei 130 °C. Belichten und Abziehen der Trägerfolie zur Entwicklung des Bilds wurden in der in Beispiel 2 beschriebenen Weise ausgeführt.

### Beispiel 7

Die abgezogene Trägerfolie aus Beispiel 2, die die belichteten Bereiche der metallfarbigen lichtempfindlichen Schicht trägt und somit ein negatives Abbild der Belichtungsvorlage auf der transparenten Trägerfolie darstellt, wurde in einem negativ arbeitenden Overlay-Farbprüfsystem (z. B. gemäß US-A 3 136 637) zur Darstellung von Metalleffekten verwendet. Die gleiche Folie kann auch auf ein nach einem negativ arbeitenden Surprint-Farbprüfverfahren erzeugtes Bild oder ein anderes mit einer Haftschicht versehenes Bildempfangsblatt als negatives Abbild einer Vorlage laminiert werden; dabei verbleibt die Trägerfolie auf der Oberfläche des Bilds.

### Beispiel 8

Auf das mehrfarbige, mit einer Metallsonderfarbe ausgestattete Farbprüfbild aus Beispiel 5 wurde unter gleichzeitiger Mattierung der glänzenden Prüfbildoberfläche eine Schutzschicht aufgebracht. Dazu wurde eine matte Polyesterträgerfolie (Melinex^{(R)} 377) mit der folgenden Lösung beschichtet und getrocknet:

| **Bestandteil** | **Gewichtsteile** |
|---|---|
| Styrol/Butadien-Copolymeres (Pliolite S 5 E, Tg 50-55 °C, M_{w} 71000) | 10 |
| n-Butylacetat | 90 |
| Das Schichtgewicht betrug 2,3 g/m². | |

Diese Folie wurde mittels eines beheizten Walzenpaares bei 115 °C mit der Schichtseite auf das Prüfbild laminiert. Nach dem Abkühlen des Laminats wurde die Trägerfolie durch Abziehen entfernt. Die Schutzschicht verblieb auf der Prüfbildoberfläche, die gleichzeitig durch die Textur der Trägerfolie verprägt war und dadurch ein mattes Aussehen erhielt.

Das folgende Beispiel betrifft ein positiv und mit Naßentwicklung arbeitendes System:

### Beispiel 9

Auf eine 50 µm dicke temporäre Trägerfolie aus leicht mattiertem, nicht haftvermitteltem Polyethylenterephthalat (^{(R)}Hostaphan RN) wurde zunächst eine Trennschicht der folgenden Zusammensetzung aufgebracht:

| **Bestandteil** | **Gewichtsteile** |
|---|---|
| Polyvinylalkohol, Hydrolysegrad 88 % | |
| M_{w} ca. 30.000 | 120 |
| M_{w} ca. 50.000 | 120 |
| Nonylphenolpolyglykolether | 6,7 |
| deionisiertes Wasser | 6800 |

Das Schichtgewicht der Trennschicht betrug nach dem Trocknen 0,8 g/m².

Danach wurde in der in Beispiel 1.1 beschriebenen Weise aus folgenden Bestandteilen eine Pigmentdispersion hergestellt:

| **Bestandteil** | | **Gewichtsteile** |
|---|---|---|
| Copolymeres aus | 14 % Vinylacetat-, | 5 |
| | 10 % Vinylalkohol- und | |
| | 76 % Vinylpropionaleinheiten | |
| Goldsatinpigment wie in Beispiel 1.1 | | 10 |
| Propylenglykolmonomethylether | | 17,5 |
| Butyrolacton | | 17,5 |

6,5 Gt dieser Dispersion wurden einer Lösung der folgenden Zusammensetzung zugesetzt:

| **Bestandteil** | **Gewichtsteile** |
|---|---|
| Polymeres von Brenzcatechinmonomethacrylat | 12,5 |
| o-Chinondiazid aus 16 Gt 2,3,4-Trihydroxybenzophenon und 3 Gt 1,2-Naphthochinon-2-diazid-4-sulfonsäurechlorid | 1,0 |
| Propylenglykolmonomethylether | 36 |
| Tetrahydrofuran | 44 |

Diese Beschichtungslösung wurde auf die mit der beschriebenen Trennschicht versehene Trägerfolie aufgetragen und getrocknet. Das Schichtgewicht der lichtempfindlichen Schicht betrug 2,5 g/m².

Auf die pigmentierte lichtempfindliche Schicht wurde abschließend eine Haftschicht der folgenden Zusammensetzung aus Toluol aufgebracht.

| **Bestandteil** | **Gewichtsteile** |
|---|---|
| Pliolite S 5 E | 97 |
| ^{(R)}Desmophen 1700 (Linearer Polyester aus Diol und Dicarbonsäure mit endständigen OH-Gruppen, Äquivalentgewicht ca. 1420) | 3 |

Das Schichtgewicht dieser Haftschicht betrug 3 g/m².

Die so erhaltene metallfarbige Folie wurde bei 130 °C unter Druck auf ein Empfangsblatt laminiert. Die temporäre Trägerfolie wurde abgezogen und die lichtempfindliche Schicht in bekannter Weise bildmäßig belichtet. Nach dem Belichten wurde mit einer wäßrig-alkalischen Lösung der folgenden Zusammensetzung entwickelt:

| **Bestandteil** | **Gewichtsteile** |
|---|---|
| Wasser | 92 |
| Natriumoctylsulfat | 3 |
| Kaliummetasilikat | 3 |
| Phenoxyethanol | 1 |
| Trinatriumphosphat | 1 |

Es wurde ein positives Abbild der Vorlage erhalten.

## Patentansprüche

1. Lichtempfindliches Material für die Herstellung metallfarbiger Bilder aus
A) einer transparenten flexiblen Trägerfolie aus Kunststoff,
B) einer 0,5 bis 20 µm dicken, lichtempfindlichen Schicht, die ein polymeres Bindemittel, eine lichtempfindliche Substanz und ein Pigment enthält, sowie
C) einer thermoplastischen Haftschicht,
dadurch gekennzeichnet, daß das Pigment ein Perlglanzpigment ist, das als Trägermaterial transparente, mineralische Partikel mit einem Durchmesser von 5 bis weniger als 50 µm enthält.

2. Lichtempfindliches Material nach Anspruch 1, dadurch gekennzeichnet, daß das Perlglanzpigment farbig ist.

3. Lichtempfindliches Material nach Anspruch 1, dadurch gekennzeichnet, daß die Perlglanzpigmentpartikel einen Durchmesser von 5 bis 20 µm haben.

4. Lichtempfindliches Material nach Anspruch 1, dadurch gekennzeichnet, daß die lichtempfindliche Schicht (B) neben dem Perlglanzpigment ein anderes Farbpigment oder einen Farbstoff enthält.

5. Lichtempfindliches Material nach Anspruch 3, dadurch gekennzeichnet, daß die Perlglanzpigmentpartikel aus einem Trägermaterial aus einem plättchenförmigen Schichtsilikat bestehen, dessen Oberfläche mit einem Weißpigment oder einem Farbpigment oder einem Farbstoff belegt ist.

6. Lichtempfindliches Material nach Anspruch 1, dadurch gekennzeichnet, daß die lichtempfindliche Schicht bei Belichtung ihre Haftung gegenüber angrenzenden Oberflächen ändert.

7. Lichtempfindliches Material nach Anspruch 1, dadurch gekennzeichnet, daß die lichtempfindliche Schicht bei Belichtung ihre Löslichkeit ändert.

8. Verfahren zur Herstellung eines metallfarbigen Bilds, dadurch gekennzeichnet, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszugsbild vor oder nach dem Laminieren bildmäßig belichtet und die Trägerfolie zusammen mit den belichteten Bereichen der lichtempfindlichen Schicht von dem Bildempfangsmaterial abzieht.

9. Verfahren zur Herstellung eines metallfarbigen Bilds, dadurch gekennzeichnet, daß man ein lichtempfindliches Material der im Anspruch 1 angegebenen Zusammensetzung mit der Haftschicht unter Druck auf ein Bildempfangsmaterial laminiert und vor oder nach dem Laminieren bildmäßig belichtet, die Trägerfolie vor oder nach dem Belichten entfernt und die belichteten oder die unbelichteten Bereiche der lichtempfindlichen Schicht mit einer Entwicklerlösung auswäscht.

10. Verfahren nach einem der Ansprüche 9 und 10, dadurch gekennzeichnet, daß das Bildempfangsmaterial ein Papierblatt ist.

11. Verfahren nach Anspruch 10, dadurch gekennzeichnet, daß das Bildempfangsmaterial ein Papierblatt mit einem darauf aufgebrachten Farbbild ist.

## Claims

1. Photosensitive material for making images bearing metal-like colours, which comprises
A) a transparent flexible plastics support film,
B) a 0.5 to 20 µm-thick photosensitive layer which contains a polymeric binder, a photosensitive substance and a pigment, and
C) a thermoplastic adhesive layer,
characterised in that the pigment is a pearlescent pigment which contains as a carrier material transparent mineral particles of a diameter of from 5 to less than 50 µm.

2. Photosensitive material according to Claim 1, characterised in that the pearlescent pigment is coloured.

3. Photosensitive material according to Claim 1, characterised in that the diameter of the pearlescent pigment particles is from 5 to 20 µm.

4. Photosensitive material according to Claim 1, characterised in that the photosensitive layer (B) contains in addition to the pearlescent pigment another coloured pigment or a dye.

5. Photosensitive material according to Claim 3, characterised in that the pearlescent pigment particles comprise a carrier material which is formed from a plate-like sheet silicate, whereof the surface is coated with a white pigment, a coloured pigment or a dye.

6. Photosensitive material according to Claim 1, characterised in that during exposure the adhesion of the photosensitive layer vis-à-vis adjacent surfaces changes.

7. Photosensitive material according to Claim 1, characterised in that during exposure the solubility of the photosensitive layer changes.

8. Process for making an image bearing metal-like colours, characterised in that a photosensitive material of the composition indicated in Claim 1 is laminated with the adhesive layer onto an image-receiving material under pressure and, before or after lamination, is exposed through the support film with a colour separation image, and the support film, together with the exposed areas of the photosensitive layer, is peeled from the image-receiving material.

9. Process for making an image bearing metal-like colours, characterised in that a photosensitive material of the composition indicated in Claim 1 is laminated with the adhesive layer onto an image-receiving material under pressure and, before or after lamination, is exposed imagewise, the support film is removed before or after exposure, and the exposed or unexposed areas of the photosensitive layer are washed out with a developer solution.

10. Process according to one of Claims 9 and 10, characterised in that the image-receiving material is a paper sheet.

11. Process according to Claim 10, characterised in that the image-receiving material is a paper sheet having applied to it a colour image.

## Revendications

1. Matériau photosensible pour la préparation d'images en couleurs métallisées, constitué de
A) une feuille support flexible transparente en matière synthétique,
B) une couche photosensible de 0,5 à 20 µm d'épaisseur, contenant un liant polymère, une substance photosensible, et un pigment, et
C) une couche adhésive thermoplastique,
caractérisé en ce que le pigment est un pigment nacré qui contient comme support des particules inorganiques transparentes ayant un diamètre compris entre 5 et moins de 50 µm.

2. Matériau photosensible selon la revendication 1, caractérisé en ce que le pigment nacré est coloré.

3. Matériau photosensible selon la revendication 1, caractérisé en ce que les particules de pigment nacré ont un diamètre de 5 à 20 µm.

4. Matériau photosensible selon la revendication 1, caractérisé en ce que la couche photosensible (B) contient, en plus du pigment nacré, un autre pigment coloré ou un colorant.

5. Matériau photosensible selon la revendication 3, caractérisé en ce que les particules de pigment nacré sont constituées d'un support formé d'un phyllosilicate en plaquettes dont la surface est revêtue d'un pigment blanc ou d'un pigment coloré ou d'un colorant.

6. Matériau photosensible selon la revendication 1, caractérisé en ce que l'adhérence de la couche photosensible aux surfaces adjacentes est modifiée lors de l'exposition.

7. Matériau photosensible selon la revendication 1, caractérisé en ce que la solubilité de la couche photosensible est modifiée lors de l'exposition.

8. Procédé de préparation d'une image en couleurs métallisées, caractérisé en ce que l'on lamine sous pression un matériau photosensible ayant la composition indiquée dans la revendication 1 avec la couche adhésive sur un matériau récepteur d'images, on l'expose suivant une image à travers la feuille support avec une image de séparation des couleurs avant ou après la formation du stratifié, et on détache la feuille support avec les zones exposées de la couche photosensible du matériau de réception d'images.

9. Procédé de préparation d'une image en couleurs métallisées, caractérisé en ce que l'on lamine sous pression un matériau photosensible ayant la composition indiquée dans la revendication 1 avec la couche adhésive sur un matériau récepteur d'images, et on l'expose suivant une image avant ou après la formation du stratifié, on enlève la feuille support avant ou après l'exposition et on enlève par lavage avec une solution de révélateur les zones exposées ou les zones non exposées de la couche photosensible.

10. Procédé selon l'une des revendications 9 et 10, caractérisé en ce que le matériau de réception d'images est une feuille de papier.

11. Procédé selon la revendication 10, caractérisé en ce que le matériau de réception d'images est une feuille de papier sur laquelle est appliquée une image en couleurs.
